# EUROPÄISCHE PATENTSCHRIFT

(11) **EP 2 332 173 B1**
(45) Veröffentlichungstag und Bekanntmachung des Hinweises auf die Patenterteilung: **15.06.2016**
(21) Anmeldenummer: 09781894.2
(22) Anmeldetag: 17.08.2009
(51) Int. Cl.: H01L 23/473, F25B 9/00, H05K 7/20, B60H 1/00

(54) **VORRICHTUNG ZUM KÜHLEN VON WÄRME ERZEUGENDEN ELEKTRONISCHEN BAUELEMENTEN MIT EINEM KÄLTEMITTEL UND DEREN VERWENDUNG**
DEVICE FOR COOLING ELECTRONIC COMPONENTS GENERATING HEAT USING A COOLANT AND ITS USE
DISPOSITIF DE REFROIDISSEMENT DE COMPOSANTS ELECTRONIQUES DEGAGEANT DE LA CHALEUR A L'AIDE D'UN AGENT FRIGORIGENE ET SON UTILISATION

(30) Priorität: 24.09.2008 DE 102008042302
(43) Veröffentlichungstag der Anmeldung: 15.06.2011
(73) Patentinhaber: Robert Bosch GmbH, 70442 Stuttgart (DE)
(72) Erfinder: KRAUSS, Andreas, 72072 Tuebingen (DE); HIRSCH, Michele, 73730 Esslingen (DE)
(86) Internationale Anmeldenummer: PCT/EP2009/060602
(87) Internationale Veröffentlichungsnummer: WO 2010/034569

(56) Entgegenhaltungen:
- EP-A- 1 830 406
- DE-A1- 4 217 289
- US-A- 2 742 765
- US-A- 3 734 810
- US-A- 3 933 004
- US-A- 3 989 102
- US-A1- 2003 221 446
- US-A1- 2006 090 494
- US-A1- 2008 223 555
- US-B1- 6 205 796
- US-B1- 6 205 803
- US-B1- 6 213 194
- US-B1- 6 438 984
- US-B1- 6 637 231

## Beschreibung

Die Erfindung betrifft eine Vorrichtung zum Kühlen von Wärme erzeugenden elektronischen Bauelementen gemäß dem Oberbegriff des Anspruches 1.

### Stand der Technik

Zur aktiven Kühlung von Wärme erzeugenden elektronischen Bauelementen von Rechnern ist es allgemein bekannt, Umgebungsluft mittels eines Gebläses oder Ventilators über die Wärme erzeugenden elektronischen Bauelemente oder einen im Wärmeleitkontakt mit den elektronischen Bauelementen stehenden Kühlkörper zu blasen.

Als Leistungselektronik bezeichnete Wärme erzeugende elektronische Bauelemente in Kraftfahrzeugen, wie beispielsweise Inverter oder Konverter eines Hybridantriebs oder eines anderen elektrische Antriebskomponenten umfassenden Antriebs der Kraftfahrzeuge weisen jedoch derartig hohe Verlustleistungen auf, dass ein sinnvoller Einsatz von Umgebungsluft weder für eine passive Kühlung durch Konvektion noch für eine aktive Kühlung möglich ist. Daher wird für derartige elektronische Bauelemente in Kraftfahrzeugen in der Regel eine aktive Kühlung mit einem flüssigen Kühlmittel vorgenommen. Als flüssiges Kühlmittel für diese Aufgabe ist das im Kühlmittelkreislauf einer Brennkraftmaschine des Kraftfahrzeugs zirkulierende Kühlwasser jedoch ungeeignet, da es eine relativ hohe Vorlauftemperatur besitzen kann. Eine zu hohe Vorlauftemperatur kann einerseits zu einer Überschreitung der maximal zulässigen Sperrschichttemperatur der Halbleiter in den elektronischen Bauelementen führen und hat andererseits eine signifikante Temperaturwechselbelastung der verschiedenen Wärme erzeugenden elektronischen Bauelemente zur Folge, was zur Erzielung der geforderten Zuverlässigkeit aufwändige Maßnahmen notwendig macht. Aus diesen Gründen wird in der Regel zur Kühlung der Bauelemente der Leistungselektronik ein flüssiges Niedertemperaturkühlmittel verwendet, das durch einen vom Kühlwasserkreislauf der Brennkraftmaschine unabhängigen Kühlmittelkreislauf umgewälzt wird.

Um die zu kühlenden elektronischen Bauelemente gegenüber dem Strom des flüssigen Kühlmittels zu kapseln, macht eine Flüssigkeitskühlung jedoch eine verhältnismäßig aufwändige Aufbau- und Verbindungstechnik für die Halbleiterbauelemente erforderlich. Um eine gute Kühlung bei gleichzeitig hohem Kühlmitteldurchsatz zu erzielen, werden überdies komplizierte Wärmetauscher benötigt.

Die Offenlegungsschrift DE 4217289 A1 offenbart eine fluidgekühlte Leistungstransistoranordnung, wobei eine Fluid-Kühlanordnung in Wärmeübertragungskontakt mit einer der Flachseiten eines Halbleiterelements steht. Bei dem Kühlfluid handelt es sich dabei entweder um ein Gas, eine Flüssigkeit oder ein Zwei-Phasen-Fluid wie beispielsweise ein Kältemittel oder CO₂. Die Offenlegungsschrift EP 1830406 A1 zeigt eine Anordnung elektronischer Leistungshalbleiterelemente mit einem Epoxidharzsubstrat, auf welchem die Leistungshalbleiterelemente befestigt sind, wobei unter dem Epoxidharzsubstrat eine Kühlvorrichtung angeordnet ist, durch welche ein Kühlmittel, beispielsweise ein Gas oder eine Flüssigkeit, strömt.

Ausgehend hiervon liegt der Erfindung die Aufgabe zugrunde, eine Vorrichtung der eingangs genannten Art dahingehend zu verbessern, dass ohne aufwändige Maßnahmen eine gute Kühlung der Wärme erzeugenden elektronischen Bauelemente ermöglicht wird.

### Offenbarung der Erfindung

Die Aufgabe wird durch eine Vorrichtung mit den Merkmalen des Anspruchs 1 erfindungsgemäß dadurch gelöst, dass die elektronischen Bauteile oder der Kühlkörper in einem geschlossenen Gehäuse mit einem Einlass und einem Auslass angeordnet sind, und der Einlass und der Auslass gasdicht mit einem geschlossenen Kältekreislauf verbunden sind, in dem das gasförmige Kühlmittel in Form eines für Kältekreisläufe geeigneten Kältemittels unter abwechselnder Verdampfung und Verflüssigung zirkuliert, und dass der geschlossene Kältekreislauf ein Kältekreislauf einer Klimaanlage eines Kraftfahrzeugs ist und dass das Gehäuse mit den elektronischen Bauelementen oder dem Kühlkörper in Strömungsrichtung des Kältemittels durch den Kältekreislauf hinter dem Kondensor und vor dem Expansionsorgan angeordnet ist, wobei hinter dem Auslass des Gehäuses ein weiterer Kondensor angeordnet ist.

Als gasförmiges Kühlmittel wird im Rahmen der vorliegenden Patentanmeldung ein Kühlmittel bezeichnet, das bei Umgebungstemperatur gasförmig ist, im Unterschied zu flüssigen Kühlmitteln, die bei Umgebungstemperatur in flüssiger Form vorliegen.

Mit den erfindungsgemäßen Maßnahmen lässt sich das Temperaturniveau der Temperatursenke der Wärme erzeugenden elektronischen Bauelemente bei gleichzeitiger Reduzierung des Volumens etwaiger Kühlkörper signifikant verringern, wobei sich zugleich die Wärmeabfuhr verbessern lässt.

Zur Kühlung von Bauelementen der Leistungselektronik von Kraftfahrzeugen wird vorzugsweise das in einem Kältekreislauf einer Klimaanlage des Kraftfahrzeugs zirkulierende bzw. umgewälzte Kältemittel verwendet, bevorzugt Kohlendioxid (CO₂), das in Zukunft verstärkt als Kältemittel für Kraftfahrzeug-Klimaanlagen eingesetzt werden wird.

Erfindungsgemäß ist der geschlossene Kältekreislauf ein Kompressionskältekreislauf, der einen Kompressor zum Verdichten des Kältemittels, einen Kondensor zum Verflüssigen des Kältemittels, ein Expansionsorgan zum Entspannen des Kältemittels und einen Verdampfer zum Verdampfen des Kältemittels umfasst, wobei der letztere beim Einsatz in einer Kraftfahrzeug-Klimaanlage zweckmäßig als Wärmetauscher dient, in dem das abgekühlte Kältemittel in Wärmetausch mit einem in einen Innenraum des Kraftfahrzeugs zugeführten Luftstrom gebracht wird.

Da die Kältekreisläufe der meisten Kraftfahrzeug-Klimaanlagen so ausgelegt sind, dass die aus dem Wärmetauscher in den Innenraum zugeführte Luft eine verhältnismäßig niedrige Temperatur aufweist, wodurch auch die Temperatur des aus dem Verdampfer austretenden Kältemittels verhältnismäßig niedrig ist, sieht eine erste bevorzugte Ausführungsvariante der Erfindung vor, dass das Kältemittel nach seinem Verdampfen den Wärme erzeugenden elektronischen Bauelementen zugeführt wird, indem man das Gehäuse mit den elektronischen Bauelementen oder dem Kühlkörper in Strömungsrichtung des Kältemittels durch den Kältekreislauf hinter dem Verdampfer und vor dem Kompressor anordnet, wobei sich der Einlass des Gehäuses auf der Seite des Verdampfers und sein Auslass auf der Seite des Kompressors befindet.

Gegebenenfalls kann das unter Druck stehende Kältemittel unmittelbar vor dem Eintritt in das Gehäuse entspannt werden, um für eine zusätzliche Abkühlung des Kältemittels zu sorgen.

Eine zweite bevorzugte Ausführungsvariante der Erfindung sieht dagegen vor, dass das Kältemittel nach dem Verflüssigen den Wärme erzeugenden elektronischen Bauelementen zugeführt wird, indem das Gehäuse mit den elektronischen Bauelementen oder dem Kühlkörper in Strömungsrichtung des Kältemittels durch den Kältekreislauf hinter dem Kondensor und vor dem Expansionsorgan angeordnet wird, wobei sich sein Einlass auf der Seite des Kondensors und sein Auslass auf der Seite des Expansionsorgans befindet. In diesem Fall ist zweckmäßig hinter dem Auslass des Gehäuses ein weiterer Kondensor angeordnet, um für eine Abkühlung des beim Hindurchtritt durch das Gehäuse erwärmten Kältemittels vor dessen Entspannung zu sorgen.

Die beiden Ausführungsvarianten können kombiniert werden, indem man den Kältekreislauf so ausführt, dass durch eine Umschaltung wahlweise das aus dem Verdampfer oder das aus dem Kondensor austretende Kältemittel den Wärme erzeugenden elektronischen Bauelementen zugeführt werden kann.

Um die Wärme erzeugenden elektronischen Bauelemente auf einer konstanten Temperatur zu halten, kann zweckmäßig ein Teil des beim Vorbeitritt an den elektronischen Bauelementen erwärmten Kältemittels durch eine Rückführleitung zum Einlass des Gehäuses zurückgeführt und dort dem zirkulierenden Kältemittel zugemischt werden.

An Stelle einer Einbindung des Gehäuses in einen Kältekreislauf einer Kraftfahrzeug-Klimaanlage kann auch eine Einbindung des Gehäuses in einen separaten, vom Kältekreislauf der Kraftfahrzeug-Klimaanlage unabhängigen Kältekreislauf vorgesehen werden, der vorzugsweise ebenfalls Kohlendioxid (CO₂) als Kältemittel nutzt. Außerdem ist es möglich, den Kältekreislauf mit einem weiteren Kältekreislauf oder mit einem Kühlwasserkreislauf einer Brennkraftmaschine des Kraftfahrzeugs zu kombinieren, zum Beispiel zur Kühlung des Kondensors.

Darüber hinaus können insbesondere in einen mit Kohlendioxid (CO₂) als Kältemittel betriebenen Kältekreislauf auch Wärme erzeugende elektrische Komponenten mit einbezogen werden, zum Beispiel eine gekapselte elektrische Maschine, wie ein Generator oder eine Lichtmaschine. Gegenüber einer herkömmlichen Kühlung, bei der ausschließlich der Stator der elektrischen Maschine gekühlt wird, hat dies den Vorteil, dass auch der Rotor aktiv gekühlt werden kann. Dadurch kann der Betriebsbereich derartiger elektrischer Maschinen erweitert und zudem Betriebszustände vermieden werden, in denen die Rotortemperatur ein begrenzendes Kriterium darstellt.

Als aktive Kühlung wird im Rahmen der vorliegenden Patentanmeldung die durch Hilfsmittel, wie zum Beispiel Pumpen, Lüfter oder Kompressoren, unterstützte Zufuhr eines Kühlmittels den zu kühlenden elektronischen Bauelementen oder elektrischen Komponenten bezeichnet, im Unterschied zur passiven Kühlung mit Umgebungsluft, bei der die Wärme allein durch Konvektion an die Umgebungsluft abgegeben wird.

Besonders bevorzugt kann die erfindungsgemäße Vorrichtung mit Kohlendioxid (CO₂) als Kältemittel zur Kühlung von Halbleiterbauelementen aus SiC verwendet werden, da dieses Halbleitermaterial eine hohe chemische und thermische Beständigkeit gegenüber Kohlendioxid aufweist und daher in direkten Kontakt mit diesem Kältemittel gebracht werden kann.

### Kurze Beschreibung der Zeichnungen

Im folgenden wird die Erfindung anhand einiger in der Zeichnung dargestellter Ausführungsbeispiele näher erläutert. Es zeigen:
Fig. 1 eine schematische Ansicht eines von einem Kältemittel durchströmten Kältekreislaufs einer Klimaanlage eines Kraftfahrzeugs und eines in den Kältekreislauf eingebundenen, Bauelemente einer Leistungselektronik des Kraftfahrzeugs enthaltenden Gehäuses;
Fig. 2 eine schematische Ansicht des Kältekreislaufs entsprechend Fig. 1, jedoch mit einer Abwandlung;
Fig. 3 eine schematische Ansicht eines anderen Kältekreislaufs einer Klimaanlage eines Kraftfahrzeugs und eines in den Kältekreislauf eingebundenen, Bauelemente einer Leistungselektronik des Kraftfahrzeugs enthaltenden Gehäuses;
Fig. 4 eine schematische Ansicht eines separaten Kältekreislaufs zur Kühlung von Leistungselektronik-Bauelementen eines Kraftfahrzeugs;
Fig. 5 eine vergrößerte geschnittene Draufsicht auf das vom Kältemittel durchströmte Gehäuse, das die Bauelemente der Leistungselektronik enthält;
Fig. 6 eine Querschnittsansicht des vom Kältemittel durchströmten Gehäuses, das an Stelle der Bauelemente der Leistungselektronik einen im Wärmekontakt mit den Bauelementen stehenden Kühlkörper enthält.

### Ausführungsformen der Erfindung

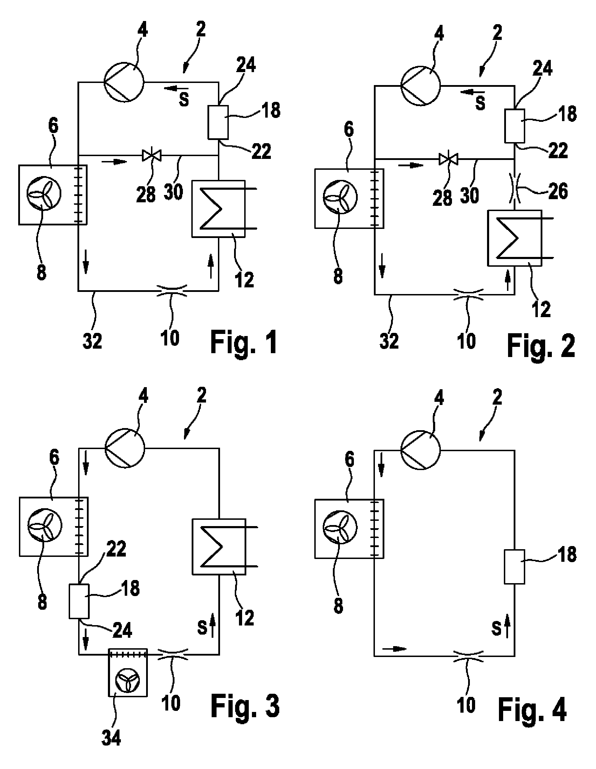

Der in den Figuren 1 bis 3 schematisch dargestellte geschlossene Kältekreislauf 2 einer Klimaanlage eines Kraftfahrzeugs mit Hybridantrieb wird in einem Carnot-Prozess von einem aus Kohlendioxid (CO₂) bestehenden, unter Druck stehenden Kältemittel durchströmt.

Der Kältekreislauf 2 besteht im Wesentlichen aus einem Kompressor 4, in dem das gasförmige Kohlendioxid (CO₂) verdichtet wird, einem in Strömungsrichtung (Pfeil S) hinter dem Kompressor 4 im Kältekreislauf 2 angeordneten Kondensor 6 oder Verflüssiger, in dem das unter Druck stehende gasförmige Kohlendioxid (CO₂) unter Abkühlung durch den Fahrtwind und unterstützt durch den Luftstrom eines Gebläses 8 verflüssigt wird, einem als Drossel ausgebildeten Expansionsorgan 10, in dem das verflüssigte Kohlendioxid (CO₂) unter Druckminderung entspannt und dabei die Temperatur des Kohlendioxids (CO₂) weiter verringert wird, sowie einem als Wärmetauscher ausgebildeten Verdampfer 12, in dem das Kohlendioxid (CO₂) verdampft und zur Zufuhr in einen Innenraum des Kraftfahrzeugs bestimmte Umgebungsluft durch Wärmetausch mit dem verdampfenden Kohlendioxid (CO₂) abgekühlt wird, bevor das letztere zur Verdichtung erneut dem Kompressor 4 zugeführt wird.

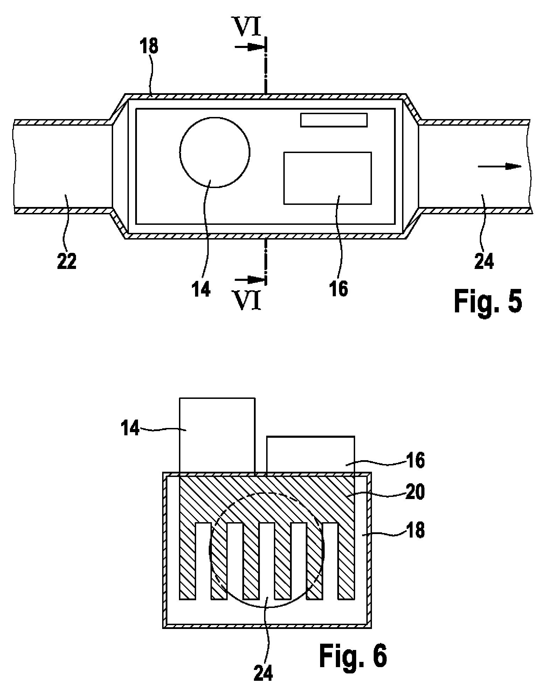

Außer zur Kühlung der in den Innenraum des Kraftfahrzeugs zugeführten Luft dient der in der Zeichnung dargestellte Kältekreislauf 2 erfindungsgemäß auch zur Kühlung von Leistungselektronik-Komponenten 14, 16 (Fig. 4 und 5) des Kraftfahrzeugs. Zu diesem Zweck umfasst der geschlossene Kältekreislauf 2 neben dem Kompressor 4, dem Kondensor 6, dem Expansionsorgan 10 und dem Verdampfer 12 ein geschlossenes, vom Kältemittel durchströmtes Gehäuse 18, das entweder die Leistungselektronik-Komponenten 14, 16 selbst (Fig. 4) oder einen Kühlkörper 20 (Fig. 5) umschließt, der im Wärmeleitkontakt mit den außerhalb des Gehäuses 18 angeordneten Leistungselektronik-Komponenten 14, 16 steht.

Bei den zu kühlenden Leistungselektronik-Komponenten 14, 16 kann es sich beispielsweise um einen Inverter, einen Konverter, Leistungshalbleiter, Leiterplatten und/oder Folienkondenstoren handeln, die in der Zeichnung nicht im Einzelnen dargestellt sind.

Wie am besten in Fig. 4 und 5 dargestellt, weist das Gehäuse 18 einen Einlass 22 und einen dem Einlass 22 gegenüberliegenden Auslass 24 auf, zwischen denen die Leistungselektronik-Komponenten 14, 16 bzw. der Kühlkörper 20 angeordnet sind, so dass ihre Oberflächen von dem durch das Gehäuse 18 geleiteten Kohlendioxid (CO₂) angeströmt werden und das an den Oberflächen vorbeiströmende Kohlendioxid (CO₂) die im Betrieb von den Leistungselektronik-Komponenten 14, 16 erzeugte Wärme abführt.

Die in Fig. 1 und 2 dargestellten Kältekreisläufe 2 sind wie die Kältekreisläufe der meisten Kraftfahrzeug-Klimaanlagen so ausgelegt, dass die aus dem Verdampfer 12 in den Innenraum des Kraftfahrzeugs zugeführte Luft eine verhältnismäßig niedrige Temperatur aufweist. Dadurch besitzt das im Kältekreislauf 2 zirkulierende Kohlendioxid (CO₂) selbst nach dem Hindurchtritt durch den Verdampfer 12 noch eine zur Kühlung der Leistungselektronik-Komponenten 14, 16 ausreichend niedrige Temperatur. Bei diesen beiden Kältekreisläufen 2 ist daher das Gehäuse 18 mit den Leistungselektronik-Komponenten 14, 16 bzw. dem Kühlkörper 20 in Strömungsrichtung des Kohlendioxids (CO₂) hinter dem Verdampfer 12 angeordnet, wobei sein Einlass 22 auf der Seite des Verdampfers 12 und sein Auslass 24 auf der Seite des Kompressors 4 angeordnet ist.

Der in Fig. 2 dargestellte Kältekreislauf 2 unterscheidet sich dabei von dem Kältekreislauf in Fig. 1 durch ein weiteres, zwischen dem Verdampfer 12 und dem Einlass 22 des Gehäuses 18 angeordnetes, als Drossel ausgebildetes Expansionsorgan 26, in dem das unter Druck stehende Kohlendioxid (CO₂) unmittelbar vor dem Eintritt in das Gehäuse 18 unter Verringerung seiner Temperatur ein weiteres Mal entspannt wird.

Um für eine konstante Temperierung der Leistungselektronik-Komponenten 14, 16 in Abhängigkeit von der in diesen erzeugten, in der Regel von den Betriebsbedingungen des Hybridantriebs bzw. einer Elektromaschine des Hybridantriebs abhängigen Wärmemenge zu sorgen, weisen die in den Figuren 1 und 2 dargestellten Kältekreisläufe 2 darüber hinaus noch eine mit einem Durchflussmengenregelventil 28 versehene Rückführleitung 30 auf, die hinter dem Kompressor 4 auf einer Hochdruckseite des Kältekreislaufs 2 aus einer den Kompressor 4, den Kondensor 6, das Expansionsorgan 10, den Verdampfer 12 und das Gehäuse 18 sowie ggf. das zweite Expansionsorgan 26 verbindenden Ringleitung 32 abzweigt und vor dem Einlass 22 des Gehäuses 18 auf einer Niederdruckseite des Kältekreislaufs 2 wieder in die Ringleitung 32 mündet.

Bei dem in Fig. 3 dargestellten Kältekreislauf 2 ist das Gehäuse 18 mit den Leistungselektronik-Komponenten 14, 16 bzw. dem Kühlkörper 20 hingegen zwischen dem Kondensor 6 und dem Expansionsorgan 10 montiert, wobei sein Einlass 22 auf der Seite des Kondensors 6 und sein Auslass 24 auf der Seite des Expansionsorgans 10 angeordnet und jeweils gasdicht mit der Ringleitung 32 verbunden ist. In diesem Fall ist in Strömungsrichtung S des Kältemittels hinter dem Gehäuse 18 ein weiterer Kondensor 34 vorgesehen, um das Kältemittel, das sich bei der Kühlung der Leistungselektronik-Komponenten 14, 16 bzw. des Kühlkörpers 20 aufgeheizt hat, vor dem Hindurchtritt durch das Expansionsorgan 10 abzukühlen.

Im Unterschied zu den Kältekreisläufen der Figuren 1 bis 3 handelt es sich bei dem in Fig. 4 dargestellten, ausschließlich zur Kühlung der Leistungselektronik-Komponenten 14, 16 dienenden Kältekreislauf 2 um einen separaten, vom Kältekreislauf der Klimaanlage unabhängigen Kältekreislauf 2, dessen Kältemittel, vorzugsweise ebenfalls Kohlendioxid (CO₂), durch das Gehäuse 18 mit den Leistungselektronik-Komponenten 14, 16 bzw. mit dem Kühlkörper 20 hindurchgeleitet wird. Bei dem in Fig. 4 dargestellten Kältekreislauf 2 ist daher das Gehäuse 18 in Strömungsrichtung des Kältemittels hinter dem Expansionsorgan 10 angeordnet.

Während bei den Kältekreisläufen 2 in den Figuren 1 bis 4 das umgewälzte Kohlendioxid (CO₂) im Kondensor 6 unter Abkühlung durch den Fahrtwind und unterstützt durch den Luftstrom des Gebläses 8 verflüssigt wird, kann zu demselben Zweck auch ein weiterer Kältekreislauf (nicht dargestellt) oder alternativ der Kühlmittelkreislauf (nicht dargestellt) einer Brennkraftmaschine des Kraftfahrzeugs verwendet werden.

## Patentansprüche

1. Vorrichtung zum Kühlen von Wärme erzeugenden elektronischen Bauelementen, mit Einrichtungen zum Zuführen eines gasförmigen Kühlmittels zu den elektronischen Bauelementen oder zu einem Kühlkörper der elektronischen Bauelemente, wobei die elektronischen Bauelemente (14, 16) oder der Kühlkörper (20) in einem geschlossenen Gehäuse (18) mit einem Einlass (22) und einem Auslass (24) angeordnet sind, und der Einlass (22) und der Auslass (24) mit einem geschlossenen Kältekreislauf (2) verbunden sind, in dem das Kühlmittel in Form eines für Kältekreisläufe geeigneten Kältemittels unter abwechselnder Verdampfung und Verflüssigung zirkuliert, wobei der Kältekreislauf (2) mindestens einen Kompressor (4) zum Verdichten des Kältemittels, einen Kondensor (6) zum Verflüssigen des Kältemittels, ein Expansionsorgan (10) zum Entspannen des Kältemittels und einen Verdampfer (12) zum Verdampfen des Kältemittels umfasst **dadurch gekennzeichnet, dass** der geschlossene Kältekreislauf ein Kältekreislauf (2) einer Klimaanlage eines Kraftfahrzeugs ist und dass das Gehäuse (18) mit den elektronischen Bauelementen (14, 16) oder dem Kühlkörper (20) in Strömungsrichtung des Kältemittels durch den Kältekreislauf (2) hinter dem Kondensor (6) und vor dem Expansionsorgan (10) angeordnet ist, wobei hinter dem Auslass (24) des Gehäuses (18) ein weiterer Kondensor (34) angeordnet ist.

2. Vorrichtung nach Anspruch 1, **gekennzeichnet durch** eine Rückführleitung (30) zum Zurückführen eines Teils des **durch** das Gehäuse (18) hindurchgeströmten Kältemittels zum Einlass (22) des Gehäuses (18).

3. Verwendung der Vorrichtung nach einem der vorangehenden Ansprüche zur Kühlung von elektronischen Halbleiterbauelementen aus SiC, wobei das aus Kohlendioxid (CO₂) bestehende Kältemittel in direkten Kontakt mit den Halbleiterbauelementen gebracht wird.

## Claims

1. Device for cooling heat-generating electronics components, having means for supplying a gaseous coolant to the electronics components or to a cooling body of the electronics components, wherein the electronics components (14, 16) or the cooling body (20) are arranged in a closed housing (18) with an inlet (22) and an outlet (24), and the inlet (22) and the outlet (24) are connected to a closed refrigeration circuit (2) in which the coolant, in the form of a refrigerant which is suitable for refrigeration circuits, circulates so as to alternately undergo evaporation and liquefaction, wherein the refrigeration circuit (2) comprises at least one compressor (4) for the compression of the refrigerant, a condenser (6) for the liquefaction of the refrigerant, an expansion element (10) for the expansion of the refrigerant, and an evaporator (12) for the evaporation of the refrigerant, **characterized in that** the closed refrigeration circuit is a refrigeration circuit (2) of an air-conditioning system of a motor vehicle, and **in that** the housing (18) with the electronics components (14, 16) or with the cooling body (20) is arranged downstream of the condenser (6) and upstream of the expansion element (10) as viewed in a flow direction of the refrigerant through the refrigeration circuit (2), wherein a further condenser (34) is arranged downstream of the outlet (24) of the housing (18).

2. Device according to Claim 1, **characterized by** a recirculation line (30) for the recirculation of a part of the refrigerant that has flowed through the housing (18) to the inlet (22) of the housing (18).

3. Use of the device according to one of the preceding claims for the cooling of electronics semiconductor components composed of SiC, wherein the refrigerant, which is composed of carbon dioxide (CO₂), is brought into direct contact with the semiconductor components.

## Revendications

1. Dispositif de refroidissement de composants électroniques dégageant de la chaleur, comprenant des dispositifs pour acheminer un réfrigérant gazeux aux composants électroniques ou à un dissipateur de chaleur des composants électroniques, les composants électroniques (14, 16) ou le dissipateur de chaleur (20) étant disposés dans un boîtier fermé (18) avec une entrée (22) et une sortie (24), et l'entrée (22) et la sortie (24) étant connectées à un circuit de refroidissement fermé (2) dans lequel le réfrigérant circule sous la forme d'un agent frigorigène approprié pour des circuits de refroidissement avec alternance d'évaporation et de liquéfaction, le circuit de refroidissement (2) comprenant au moins un compresseur (4) pour comprimer l'agent frigorigène, un condenseur (6) pour liquéfier l'agent frigorigène, un organe d'expansion (10) pour détendre l'agent frigorigène et un évaporateur (12) pour évaporer l'agent frigorigène, **caractérisé en ce que** le circuit de refroidissement fermé est un circuit de refroidissement (2) d'une installation de climatisation d'un véhicule automobile et **en ce que** le boîtier (18) avec les composants électroniques (14, 16) ou le dissipateur de chaleur (20) est disposé dans la direction d'écoulement de l'agent frigorigène à travers le circuit de refroidissement (2) derrière le condenseur (6) et avant l'organe d'expansion (10), un condenseur supplémentaire (34) étant disposé derrière la sortie (24) du boîtier (18).

2. Dispositif selon la revendication 1, **caractérisé par** une conduite de recirculation (30) pour recirculer une partie de l'agent frigorigène guidé à travers le boîtier (18) jusqu'à l'entrée (22) du boîtier (18).

3. Utilisation du dispositif selon l'une quelconque des revendications précédentes pour refroidir des composants semi-conducteurs électroniques en SiC, l'agent frigorigène constitué de dioxyde de carbone (CO₂) étant amené en contact direct avec les composants semi-conducteurs.
